# EUROPEAN PATENT APPLICATION

(11) **EP 2 242 152 A1**
(43) Date of publication of application: **20.10.2010**
(21) Application number: 09701495.5
(22) Date of filing: 15.01.2009
(51) Int. Cl.: H01S 5/022

(54) **OPTICAL MODULE**

(30) Priority: 16.01.2008 JP 2008007442; 16.01.2008 JP 2008007443
(71) Applicant: FURUKAWA ELECTRIC CO., LTD., Tokyo 100-8322 (JP)
(72) Inventor: NASU, Hideyuki, Tokyo 100-8322 (JP); ISHIKAWA, Yozo, Tokyo 100-8322 (JP)
(74) Representative: Patentship
(86) International application number: PCT/JP2009/050448
(87) International publication number: WO 2009/090988

(57) **Abstract**

Provided is an optical module for transmit light signals in parallel with a plurality of optical fibers, the optical module including: a board to have an electrode pattern; a plurality of optical elements which are mounted on the electrode pattern of the board; and an electronic device which is mounted on the electrode pattern of the board and which is electrically connected to the plurality of optical elements, wherein the plurality of optical elements and the electronic device are arranged on the board in such that lengths of transmission lines to transmit signals between the plurality of optical elements and the electronic device become shortest.

## Description

### Technical Field

The present invention relates to an optical module, and more particularly to an optical module as a parallel optical transmission module to be used for an inter-board optical transmission system and an inter-apparatus (inter-housing) optical transmission system, which parallel optical transmission module parallelly transmits optical signals with a plurality of optical fibers (channels) arranged in parallel.

### Background Art

An optical module composed of a plurality of light emitting elements and an electronic device (IC) driving the plurality of light emitting elements, both housed in a case to be integrated, has hitherto been known (see, for example, Patent Document 1).

Furthermore, an optical module composed of a plurality of laser diodes, or a plurality of photodiodes, and an IC (a driver IC driving each laser diode or an amplifying IC processing an output of each photodiode), both housed in a case to be integrated, has been known (see, for example, Non-Patent Document 1).
Patent Document 1: Japanese Patent Application Laid-Open Publication No. 2002-261372
Non-Patent Document 1: (In Japanese) Toshiyuki Okayasu, "Memori-testo-shisutemu ni okeru koumitsudo inta-konekusyon", dainikai sirikon anarogu RF kenkyu-kai, 2004/8/2 (Toshiyuki Okayasu, "high density interconnection on a memory test system," Second Silicon Analog RF Study Meeting, 8/2/2004)

### Disclosure of Invention

### Problems to Be Solved by the Invention

Incidentally, the conventional optical modules disclosed in the Patent Document 1 and the Non-Patent Document 1 are adapted to accord each center of the plurality of optical fibers, held by a ferrule, with the center of each light emitting section of the plurality of optical elements by passive alignment using a silicon optical bench (SiOB). Because the SiOB intervenes between the plurality of optical elements and the electronic device (IC) in the conventional technique of this configuration, the configuration of the technique is that of electrically connecting the plurality of optical elements and the electronic device with the wiring on the SiOB. Namely, the configuration is the following one: the plurality of optical elements are connected to the wiring on the SiOB with wires, and the wiring is connected to the electronic device with wires. Hereby, the lengths of a plurality of transmission lines connecting the plurality of light emitting elements and the electronic device electrically becomes long. Consequently, crosstalk components between adjacent transmission lines increase, and there is a problem of the difficulty of realizing high speed parallel light transmission.

The present invention was devised in view of such a conventional problem and aims at providing an optical module making it possible to realize high speed parallel light transmission by reducing crosstalk components.

### Means for Solving the Problems

In order to solve the above problem, an optical module according to the invention of claim 1 is an optical module to parallely transmit light signals with a plurality of optical fibers, the optical module including: a board to have an electrode pattern; a plurality of optical elements which are mounted on the electrode pattern of the board; and an electronic device which is mounted on the electrode pattern of the board and which is electrically connected to the plurality of optical elements, wherein the plurality of optical elements and the electronic device are arranged on the board in such a way that lengths of transmission lines to transmit signals between the plurality of optical elements and the electronic device become shortest.

According to the configuration, crosstalk between adjacent transmission lines can be reduced, and high speed parallel light transmission can be realized.

An optical module of the invention according to claim 2 is the optical module according to claim 1 further including an optical connector section to hold the plurality of optical fibers, which optical connector section is fixed on the board at a position where the plurality of optical fibers and the plurality of optical elements are optically coupled to each other, respectively, wherein a position of the optical connector section can two-dimensionally be adjusted on the board.

According to the configuration, active alignment is performed in such a way that the plurality of optical fibers and the plurality of optical elements are optically coupled to each other, respectively, by two-dimensionally adjusting the position of the optical connector section on the board. Consequently, the SiOB for performing the passive alignment becomes unnecessary unlike the conventional technique, and the plurality of optical elements and the electronic device can be arranged at positions on the board close to each other. Hereby, the lengths of the plurality of transmission lines connecting the plurality of light emitting elements and the electronic device electrically can be shortened. In addition, "a position where the plurality of optical fibers and the plurality of optical elements are optically coupled to each other, respectively" means the position where the center (core center) of each one end of the plurality of optical fibers and the center of each light emitting section or each light receiving section of the plurality of optical elements accord with each other, respectively.

An optical module of the invention according to claim 3 features that the electronic device is arranged in a recess section formed on the board in order that heights of surfaces of the plurality of optical elements and a height of a surface of the electronic device become comparative levels in order that wire lengths become shortest, and the surfaces of the plurality of optical elements and the surface of the electronic device are directly electrically connected to each other, respectively, with a plurality of wires as the transmission lines.

According to the configuration, crosstalk between adjacent wires can be reduced in the optical module in which the plurality of optical elements and the electronic device are mounted by wire bonding.

An optical module of the invention according to claim 4 features that the recess section has almost vertical wall surfaces; the plurality of optical elements are arranged on the board so as to align along one of the wall surfaces at a position close to the one of the wall surfaces; and the electronic device is arranged in the recess section at a position close to the one of the wall surfaces.

According to the configuration, because the plurality of optical elements and the electronic device can be arranged to be closer to each other, the lengths of the transmission lines can furthermore be shortened. Hereby, crosstalk between adjacent transmission lines can furthermore be reduced, and high speed parallel light transmission can be realized.

An optical module of the invention according to claim 5 features that the electronic device is mounted on the board by flip chip mounting; the plurality of optical elements are arranged in a recess section formed on the board in order that heights of surfaces of the plurality of optical elements and a height of a surface of the electronic device become comparative levels in order that wire lengths become shortest; and the plurality of optical elements and wiring on the board, to which wiring the electronic device is electrically connected, are electrically connected to each other with a plurality of wires.

According to the configuration, crosstalk between adjacent transmission lines can be reduced in the optical module in which the electronic device is mounted on the board by the flip chip mounting. In addition, the transmission lines for transmitting signals between the plurality of optical elements and the electronic device are composed of the wiring on the board, to which wiring the electronic device is electrically connected, and the plurality of wires in this case.

An optical module of the invention according to claim 6 features that the plurality of optical elements are surface emitting type semiconductor laser elements to severally emit a light from back surface side thereof; the plurality of optical elements are mounted on the board by flip chip mounting; the electronic device is arranged in a recess section formed on the board in order that a height of a front surface of the electronic device and a height of a front surface of the board become comparative levels in order that wire lengths become shortest; and the electronic device and wiring on the board, to which wiring the plurality of optical elements are electrically connected, are electrically connected to each other with a plurality of wires.

According to the configuration, crosstalk between adjacent transmission lines can be reduced in the optical module mounting the plurality of optical elements on the board by the flip chip mounting, each of which optical elements is a surface emitting type semiconductor laser element (back surface light emitting type VCSEL) emitting a light from its back surface side. In addition, in this case, the transmission lines transmitting signals between the plurality of optical elements and the electronic device are composed of the wiring on the board, to which wiring the plurality of optical elements are electrically connected, and the plurality of wires.

An optical module of the invention according to claim 7 features that the electronic device is arranged in a recess section formed on the board; surfaces of the plurality of optical elements and a surface of the electronic device are directly electrically connected to each other with a plurality of wires as the transmission lines; and the surface of the electronic device is made to be higher than the surfaces of the plurality of optical elements within a range in which no electrical short circuits are caused at respective both ends of the plurality of wires.

According to the configuration, each of the wire lengths can be shortened as short as possible without causing any electrical short circuit at each of both the ends of the plurality of wires.

An optical module of the invention according to claim 8 features that the electronic device is arranged in a recess section formed on the board; surfaces of the plurality of optical elements and a surface of the electronic device are directly electrically connected to each other with a plurality of wires as the transmission lines; and the surfaces of the plurality of optical elements are made to be higher than the surface of the electronic device within a range in which no electrical short circuits are caused at respective both ends of the plurality of wires.

According to the configuration, each of the wiring lengths can be shortened as short as possible without causing any electrical short circuit at each of both the ends of the plurality of wires.

An optical module of the invention according to claim 9 features that the optical module includes a plurality of surface emitting type semiconductor laser elements as the optical elements and a driver IC as the electronic device, which driver IC drives the plurality of surface emitting type semiconductor laser elements, and the optical module is configured as a transmission side optical module to transmit the optical signals to be emitted from the plurality of surface emitting type semiconductor laser elements, respectively, to an outside through the plurality of optical fibers in parallel.

According to the configuration, the transmission side optical module capable of performing high speed parallel light transmission can be realized.

An optical module of the invention according to claim 10 features that the optical module includes a plurality of photodiodes as the optical elements and an amplifying IC as the electronic device, which amplifying IC has a function to convert output currents of the photodiodes into voltages to amplify the voltage, and the optical module is configured as a reception side optical module to receive the optical signals, which are parallelly transmitted from an outside through the plurality of optical fibers, with the plurality of photodiodes to convert the received optical signals into electric signals.

According to the configuration, the reception side optical module capable of performing high speed parallel light transmission can be realized.

In order to solve the above problem, an optical module of the invention according to claim 11 is an optical module to parallelly transmit optical signals with a plurality of optical fibers, the optical module including: a board having an electrode pattern; a plurality of optical elements which are mounted on the electrode pattern of the board; and an electronic device which is mounted on the electrode pattern of the board and which is electrically connected to the plurality of optical elements, wherein the plurality of optical elements and the electronic device are arranged at positions close to each other on the board. According to the configuration, the lengths of a plurality of transmission lines connecting the plurality of light emitting elements and the electronic device to each other electrically become short, and crosstalk between adjacent transmission lines can be reduced. Hereby, high speed parallel light transmission can be realized.

An optical module of the invention according to claim 12 further includes an optical connector section to hold the plurality of optical fibers, which optical connector section is fixed to the board at a position where the plurality of optical fibers and the plurality of optical elements are optically coupled to each other, respectively, and a position of the optical connector section can two-dimensionally be adjusted on the board. According to the configuration, the configuration is the one performing the active alignment in order that the plurality of optical fibers and the plurality of optical elements may optically coupled to each other, respectively, byperformingtwo-dimensionalposition adjustment of the optical connector section on the board. Consequently, the SiOB for performing the passive alignment becomes unnecessary unlike the conventional technique, and the plurality of optical elements and the electronic device can be arranged at positions close to each other on the board. Hereby, the lengths of the plurality of transmission lines connecting the plurality of light emitting elements and the electronic device to each other electrically can be shortened. In addition, "a position where the plurality of optical fibers and the plurality of optical elements are optically coupled to each other, respectively" indicates the position where the center (core center) of each one end of the plurality of optical fibers and the center of each light emitting section or each light receiving section of the plurality of optical elements accord with each other, respectively.

An optical module of the invention according to claim 13 features that the electronic device and the plurality of optical elements are directly electrically connected to each other, respectively, with a plurality of wires. According to the configuration, the wire lengths of the plurality of wires connecting the plurality of light emitting elements and the electronic device electrically become short. Hereby, crosstalk between adjacent wires can be reduced in the optical module in which the electronic device and the plurality of optical elements are mounted by wire bonding mounting.

An optical module of the invention according to claim 14 features that each of lengths in horizontal directions of the plurality of wires is made to be 500 µm or less. According to the configuration, the crosstalk between adjacent wires (channels) at the time of the transmission at the rate of 10 Gbit/s (< 8 GHz) can be suppressed to be 30 dB or less.

An optical module of the invention according to claim 15 features that the electronic device is mounted on the board by flip chip mounting, and the plurality of optical elements and wiring on the board, to which the electronic device is electrically connected, are electrically connected to each other, respectively, with a plurality of wires. According to the configuration, a plurality of transmission lines are composed of the plurality of wires and the wiring, respectively, which wires and wiring electrically connect the plurality of optical elements and the electronic device to each other, respectively, and consequently the lengths of the plurality of transmission lines become short. Hereby, crosstalk between adjacent transmission lines can be reduced in the optical module including the electronic device mounted on the board by the flip chip mounting.

An optical module of the invention according to claim 16 features that lengths of a plurality of transmission lines composed of the plurality of wires and the wiring, which wires and wiring electrically connect the plurality of optical elements and the electronic device, respectively, are made to be 500 µm or less. According to the configuration, the crosstalk between adjacent wires (channels) at the time of the transmission at the rate of 10 Gbit/s (< 8 GHz) can be suppressed to be 30 dB or less.

An optical module of the invention according to claim 17 features that the optical module is configured as a transmission side optical module to include a plurality of surface emitting type semiconductor laser elements as the optical elements and a driver IC as the electronic device to drive the plurality of surface emitting type semiconductor laser elements, which transmission side optical module parallelly transmits optical signals emitted from the plurality of surface emitting type semiconductor laser elements, respectively, to an outside through the plurality of optical fibers. According to the configuration, the transmission side optical module capable of high speed parallel light transmission can be realized.

An optical module of the invention according to claim 18 features that the optical module is configured as a reception side optical module to include a plurality of photodiodes as the optical elements and an amplifying IC as the electronic device to have a function of converting output currents of the photodiodes into voltages to amplify the voltages, which reception side optical module receives optical signals transmitted parallely from an outside through the plurality of optical fibers with the plurality of photodiodes to convert the received optical signals into electric signals. According to the configuration, the reception side optical module capable of high speed parallel light transmission can be realized.

### Effects of the Invention

According to the present invention, crosstalk components can be reduced, and high speed parallel light transmission can be realized.

### Brief Description of Drawings

[FIG. 1] FIG. 1 is a perspective view showing the principal part of an optical module according to a first embodiment of the present invention.
[FIG. 2] FIG. 2 is a sectional view of FIG. 1.
[FIG. 3] FIG. 3 is a longitudinal sectional view showing the schematic configuration of the module according to the first embodiment.
[FIG. 4A] FIG. 4A is a perspective view showing the whole optical module according to the first embodiment.
[FIG. 4B] FIG. 4B is an enlarged view showing an optical fiber.
[FIG. 4C] FIG. 4C is a plan view showing the connection relation between each surface emitting type semiconductor laser element of a laser diode array and a driver IC.
[FIG. 5] FIG. 5 is an exploded perspective view showing the optical module of the first embodiment.
[FIG. 6] FIG. 6 is a perspective view showing an optical connector section of the optical module.
[FIG. 7] FIG. 7 is a perspective view showing a state in which an external connector is mounted on the optical connector section.
[FIG. 8] FIG. 8 is a perspective view showing the principal part of an optical module according to a second embodiment.
[FIG. 9] FIG. 9 is a sectional view according to the principal part of an optical module according to a third embodiment.
[FIG. 10] FIG. 10 is a sectional view showing the principal part of an optical module according to a fourth embodiment.
[FIG. 11] FIG. 11 is a sectional view showing the principal part of an optical module according to a fifth embodiment.
[FIG. 12] FIG. 12 is an explanatory view of an example of a sixth embodiment.
[FIG. 13] FIG. 13 is a graph showing comparisons of crosstalk between adjacent channels of a conventional model and a proposed model.

### Best Mode for Carrying Out the Invention

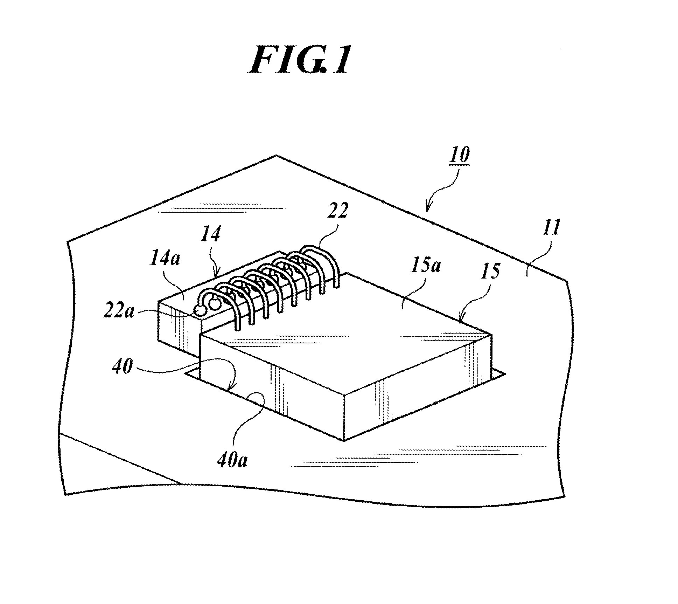

Next, each embodiment embodying the present invention will be described with reference to the accompanying drawings. In addition, similar parts will be denoted by the same marks in the description of each embodiment to omit duplicate descriptions.
(First Embodiment)An optical module according to a first embodiment will be described with reference to FIGS. 1-7.

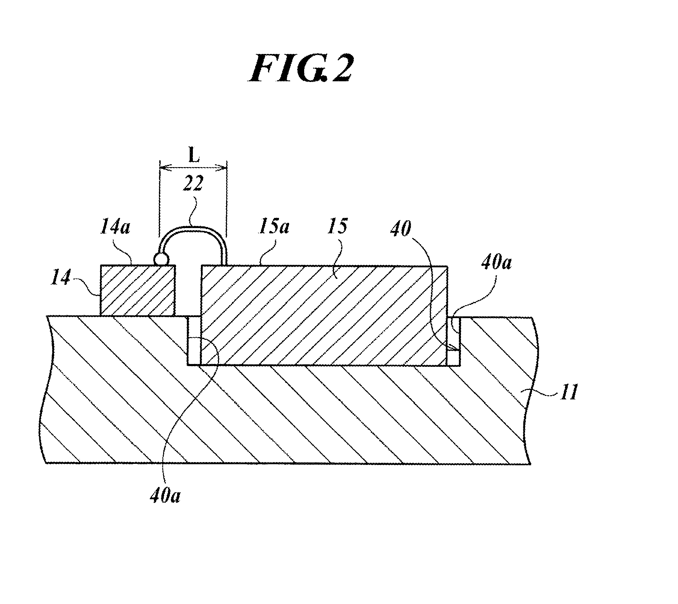

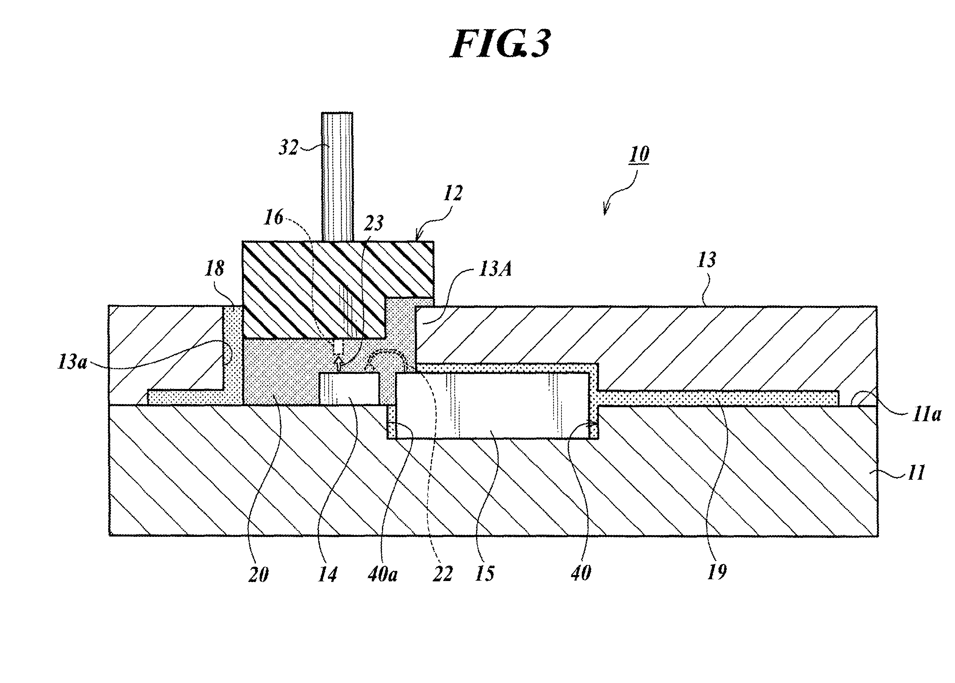

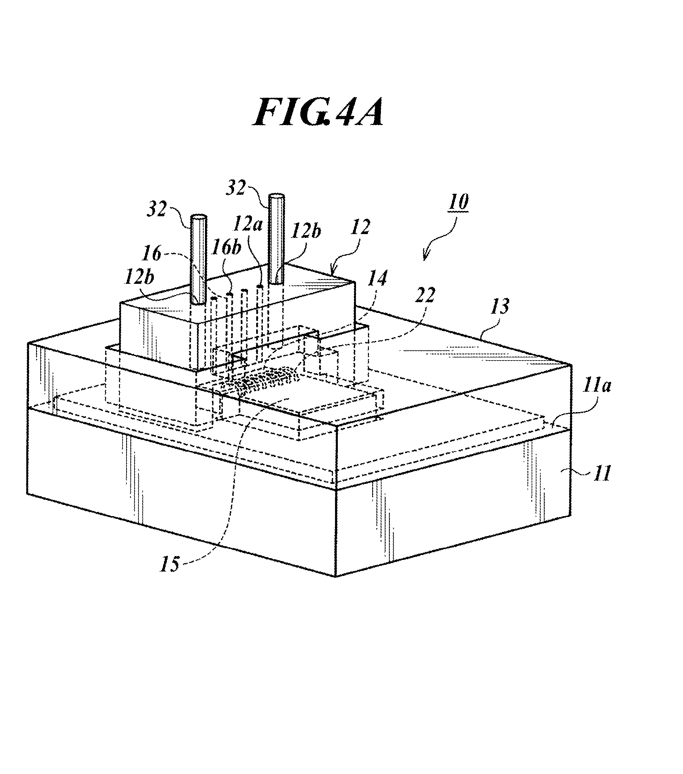

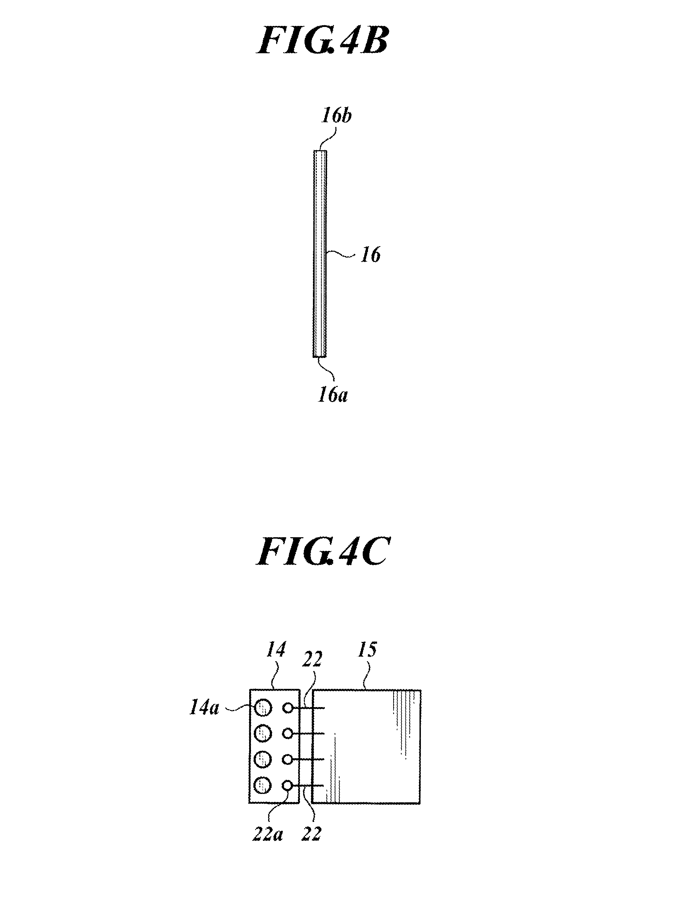

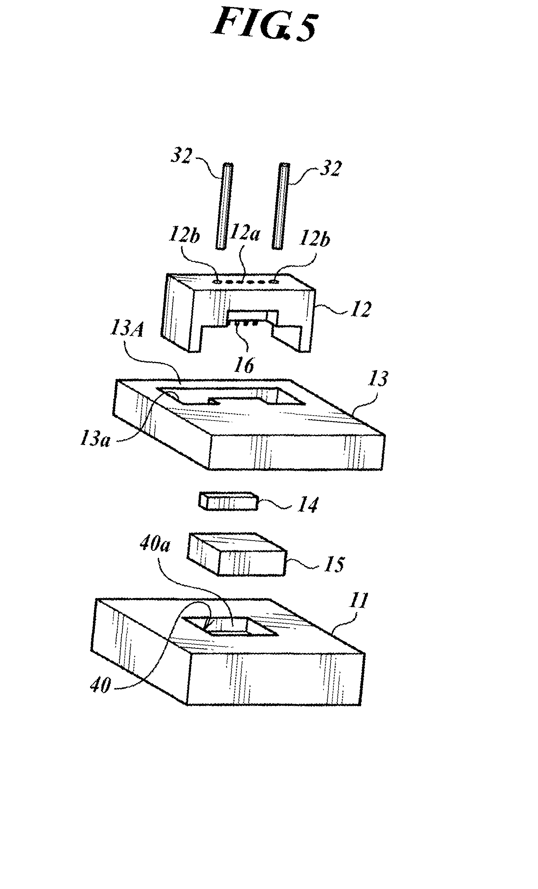

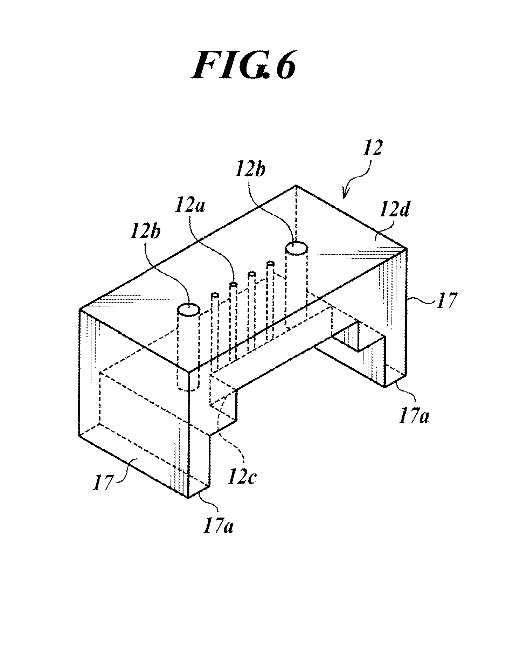

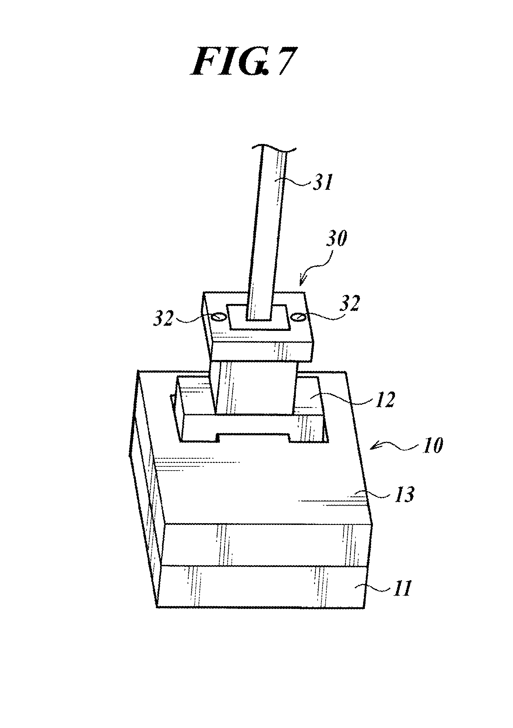

FIG. 1 is a perspective view showing the principal part of the optical module according to the first embodiment, and FIG. 2 is a sectional view of FIG. 1. FIG. 3 is a longitudinal sectional view showing the schematic configuration of the optical module. FIG. 4A is a perspective view showing the whole optical module; FIG. 4B is an enlarged view showing one of a plurality of optical fibers to be used for the optical module; and FIG. 4C is a plan view showing the connection relation between each surface emitting type semiconductor laser element of a laser diode array to be used for the optical module and a driver IC. FIG. 5 is an exploded perspective view showing the schematic configuration of the optical module; FIG. 6 is a perspective view showing an optical connector section of the optical module; and FIG. 7 is a perspective view showing a state in which an external connector (multicore ferrule type connector) is mounted on the optical connector section of the optical module.

The optical module 10 accordingtothe first embodiment is the one for parallelly transmitting optical signals with a plurality of optical fibers. As shown in FIGS. 1 and 2, the optical module 10 includes a board 11 having an electrode pattern (not shown), a plurality of optical elements mounted on the electrode pattern in a line, and an electronic device mounted on the electrode pattern to be electrically connected to the plurality of optical elements.

The board 11 is a ceramic board. In the present embodiment, the plurality of optical elements are composed of a laser diode array 14 including a plurality of surface emitting type semiconductor laser elements (optical elements) aligned in a line. A mark 14a in FIG. 4C denotes each light emitting section (aperture section) of the plurality of surface emitting type semiconductor laser elements of the laser diode array 14. A surface emitting type semiconductor laser element as an optical element is a vertical cavity surface emitting laser (VCSEL), emitting a light (optical signal 23) into the direction perpendicular to a board surface. Furthermore, the electronic device is a driver IC 15 driving the plurality of surface emitting type semiconductor laser elements of the laser diode array 14.

A feature of the optical module 10 exists in the respect of the arrangement of the laser diode array 14 and the driver IC on the board 11 in such a way that the lengths of a plurality of wires (transmission lines) 22, each transmitting a signal between each of the plurality of surface emitting type semiconductor laser elements of the laser diode array 14 and the driver IC 15, becomes shortest as shown FIGS. 1 and 2. To put it concretely, the driver IC 15 is arranged in a recess section 40 formed on the board 11 in such a way that the height of the front surface (surface) 14a of the laser diode array 14 and the height of the front surface (surface) 15a of the driver IC 15 become comparable levels in order that the wire lengths may become shortest.

Furthermore, in the optical module 10, the wall surfaces 40a of the recess section 40 are made to be almost vertical in order to enable the laser diode array 14 and the driver IC 15 to be arranged to be close to each other in order to shorten the plurality of wires 22. Then, the laser diode array 14 is arranged on the board 11 at a position close to one of the wall surfaces 40a, and the driver IC 15 is arranged at a position in the recess section 40 close to the wall surface 40a.

The laser diode array 14 is mounted on the front surface 11a of the board 11 by being adhered thereon with, for example, a die attach adhesive. The driver IC 15 is mounted on the bottom surface of the recess section 40 by being adhered thereon with, for example, a die attach adhesive with a part of the driver IC 15 housed in the recess section 40 of the board 11. The recess section 40 is a rectangular hole having the almost vertical wall surfaces 40a. The laser diode array 14 is arranged on the front surface 11a of the board in such a way that one of the end faces becomes close to one of the wall surfaces 40a. On the other hand, the driver IC 15 is arranged on the bottom surface of the recess section 40 in such a way that one of the end faces is close to the wall surface 40a. The laser diode array 14 and the driver IC 15 are arranged on the board 11 at the positions close to each other in this way. Then, the driver IC 15 and the plurality of surface emitting type semiconductor laser elements of the laser diode array 14, namely, the electrodes on the front surface 15a of the driver IC 15 and the electrodes of the respective surface emitting type semiconductor laser elements on the front surface 14a of the laser diode array 14, are directly electrically connected with the plurality of wires 22 as the transmission lines, respectively (see, FIGS. 1, 2, and 4C).

Namely, the driver IC 15 and the plurality of surface emitting type semiconductor laser elements of the laser diode array 14 are electrically connected to each other, respectively, with the plurality of wires 22 without any wiring on an SiOB unlike the conventional technique described above. Hereby, the optical module 10 is configured in order that a modulation signal may be input from the driver IC 15 to each surface emitting type semiconductor laser element of the laser diode array 14 through each of the bonding wires 22, and that the optical signal 23, modulated by the modulation signal, is emitted from each surface emitting type semiconductor laser element of the laser diode array 14. Furthermore, the driver IC 15 and the electrode pattern of the board 11 are electrically connected to each other with a not-shown plurality of bonding wires. A mark 22a in FIG. 4C denotes a ball fused to the electrode of each surface emitting type semiconductor laser element.

The optical module 10 furthermore includes an optical connector section 12, a cover 13, and two guide pins 32 as shown in FIGS. 3, 4A, and 5.

The optical connector section 12 holds a plurality of optical fibers 16, aligned in a line (in the direction perpendicular to the paper surface in FIG 3), as shown in FIGS. 4A-4C and 6. The optical connector section 12 is aligned by the active alignment in such a way that the center (core center) of each of one ends 16a (see FIG. 4B) of the plurality of optical fibers 16 and the center of each of the light emitting sections 14a of the laser diode array 14 accord with each other, and, after that, the optical connector section 12 is fixed on the front surface 11a of the board 11. Hereby, the optical module 10 is adapted to optically couple each emitted light (optical signal 23) from each of the light emitting sections 14a of the laser diode array 14 to each of the one ends 16a of the optical fibers corresponding to the plurality of optical fibers 16.

Furthermore, the optical connector section 12 has side wall sections 17 on both sides as shown in FIG. 6. The lower end faces 17a of both the side wall sections 17 severally contact with the front surface 11a of the board 11 in a slidable state. The optical connector section 12 is two-dimensionally moved on the front surface 11a of the board 11 by the active alignment in order that the center of each of the one ends 16a of the plurality of optical fibers 16 and the center of each of the light emitting sections 14a of the laser diode array 14 may accord with each other, and after that, the lower end faces 17a of both the side wall sections 17 of the optical connector section 12 are fixed to the front surface 11a of the board 11 by adhering or the like.

Furthermore, as shown in FIG. 6, the optical connector section 12 includes a plurality of fiber holding holes 12a, into which the plurality of optical fibers 16 are fitted, which fiber holding holes 12a are aligned in a line, and two guide pin holes 12b provided on both the sides of the fiber holding holes 12a. The two guide pins 32 are adapted to be able to fit into the two guide pin holes 12b.

The two guide pins 32 are adapted to be able to fit into two through-holes, respectively, of a multicore optical fiber connector (hereinafter referred to as an MT connector) 30, shown in FIG. 7, which is an external connector. By fitting the two through-holes of the MT connector 30 into the two guide pins 32, respectively, the MT connector 30 is adapted to be mounted onto the optical connector section 12, as shown in FIG. 7, in the state in which the center (core center) of each of the optical fibers of a multicore optical fiber (multicore tape optical fiber) 31, held by the MT connector 30, and each of the centers (core centers) of the plurality of optical fibers 16, held by the optical connector section 12, accord with each other.

As shown in FIGS. 3, 4A, and 5, the cover 13 includes an aperture section 13a for mounting the optical connector section 12, and is fixed to the board 11 by adhesion or the like in order to cover all the parts, such as the laser diode array 14 and the driver IC 15. The cover 13 is made of a material having high thermal conductivity, such as an alloy of copper (Cu) and tungsten (W).

Furthermore, a resin 18, such as a resin sealing compound or an adhesive, is filled in a space between a side face of the optical connector section 12 and the aperture section 13a of the cover 13 as shown in FIG. 3. A silicone gel 19, having heat conductance and insulation properties, is filled in as a sealing compound in a gap (space) between the driver IC 15 and the cover 13. Furthermore, a transparent silicone gel 20 is filled in the space between each of the one ends 16a of the plurality of optical fibers 16 and each of the light emitting sections 14a of the laser diode array 14 as a sealing compound.

The first embodiment, configured as described above, takes the following operations and effects.
○ The laser diode array 14 and the driver IC are arranged on the board 11 in such a way that the lengths of the plurality of wires (transmission lines) 22 for transmitting signals between the plurality of surface emitting type semiconductor laser elements of the laser diode array 14 and the driver IC 15, respectively, become shortest. Hereby, crosstalk between adjacent ones of the wires 22 can be reduced, and high speed parallel light transmission can be realized.

○ Because the driver IC 15 is arranged in the recess section 40 in order that the height of the front surface (surface) 14a of the laser diode array 14 and the height of the front surface (surface) 15a of the driver IC 15 may be comparable levels in order that the wire lengths may be shortest and the front surface 14a and the front surface (surface) 15a are directly electrically connected to each other, respectively, with the plurality of wires 22 as the transmission lines, the wire lengths L of the plurality of wires 22 (see FIG. 2) become short. Hereby, crosstalk between adjacent ones of the wires 22 can be reduced in the optical module in which the laser diode array 14 and the driver IC 15 are mounted by the wire bonding mounting.

○ The first embodiment is configured in order that the plurality of optical fibers 16 and the plurality of surface emitting type semiconductor laser elements of the laser diode array 14 may be optically coupled to each other, respectively, by the active alignment by performing two-dimensional position adjustment of the optical connector section 12 on the board 11. Namely, by the active alignment, the center of each of the one ends 16a of the plurality of optical fibers 16 and the center of each of the light emitting sections 14a of the laser diode array 14 accord with each other. Consequently, the SiOB for performing the passive alignment becomes unnecessary unlike the conventional technique described above, and the laser diode array 14 and the driver IC 15 can be arranged on the board 11 at positions close to each other. Hereby, the wire lengths L of the plurality of wires 22, connecting the plurality of surface emitting type semiconductor laser elements of the laser diode array 14 and the driver IC 15 to each other electrically, can be shortened, and crosstalk between adjacent ones of the wires 22 can be reduced.

○Because the wall surfaces 40a of the recess section 40 are made to be almost vertical, the laser diode array 14 and the driver IC 15 can be arranged to be close to each other, and the plurality of wires 22 can be shortened. Hereby, crosstalk between adjacent ones of the wires 22 can be reduced, and high speed parallel light transmission can be realized.

### (Second Embodiment)

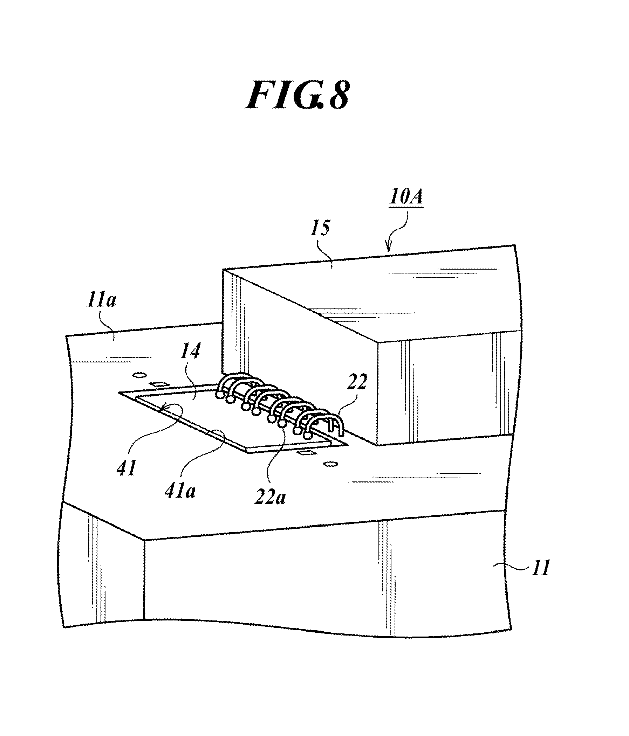

An optical module 10A according to a second embodiment will be described with reference to FIG. 8.

In the first embodiment described above, the driver IC 15 is mounted on the electrode pattern of the board 11 by the wire bonding. On the other hand, the features of the optical module 10A according to the second embodiment exist in the following configuration.

• As shown in FIG. 8, the driver IC 15 is mounted on the electrode pattern of the board 11 by the flip chip mounting.

• The laser diode array 14 is arranged in a recess section 41 formed on the board 11 in order that the height of the front surface 14a of the laser diode array 14 and the height of the front surface 11a of the board 11 may be comparable levels in order that the wire lengths become shortest.

• The plurality of surface emitting type semiconductor laser elements of the laser diode array 14 and the wiring on the board 11 to which wiring the driver IC 15 is electrically connected are connected to each other with the plurality of wires 22.

The other configuration is similar to that of the optical module 10 of the first embodiment described above.

By such a configuration, the lengths of the plurality of wires (transmission lines) 22 for transmitting signals between the plurality of surface emitting type semiconductor laser elements of the laser diode array 14 and the driver IC 15, respectively, are made to be shortest.

The whole of the laser diode array 14 is housed in the recess section 41 of the board 11 and is mounted on the bottom surface of the recess section 41 by, for example, being adhered with a die attach adhesive. The recess section 41 is a rectangular hole having almost vertical wall surfaces 41a and almost the same depth as the height of the laser diode array 14. The laser diode array 14 is arranged in the recess section 41 in such a way that one of the end faces thereof becomes close to one of the wall surfaces 41a. On the other hand, the driver IC 15 is mounted on the electrode pattern of the board 11 in such a way that one of the end faces of the driver IC 15 becomes close to the wall surface 41a. In this way, the laser diode array 14 and the driver IC 15 are arranged at positions on the board 11 close to each other. Then, the plurality of surface emitting type semiconductor laser elements of the laser diode array 14 and the wiring (a part of the electrode pattern) to which the driver IC 15 is electrically connected are electrically connected to each other, respectively, with the plurality of wires 22.

The second embodiment configured as described above takes the following operations and effects in addition to the operations and effects taken by the first embodiment.

○ Cross talk between adjacent transmission lines can be reduced in the optical module mounting the driver IC 15 on the board 11 by the flip chip mounting. In addition, the transmission lines for transmitting signals between the plurality of surface emitting type semiconductor laser elements of the laser diode array 14 and the driver IC 15 are each composed of the wiring on the board 11, to which wiring the drive IC 15 is electrically connected, and the plurality of wires 22 in this case.

○ Because the wall surfaces 41a of the recess section 41 are made to be almost vertical, the laser diode array 14 and the driver IC 15 can be arranged to be close to each other, and the plurality of wires 22 can be shortened. Hereby, crosstalk between adjacent ones of the wires 22 can be reduced, and high speed parallel light transmission can be realized.

### (Third Embodiment)

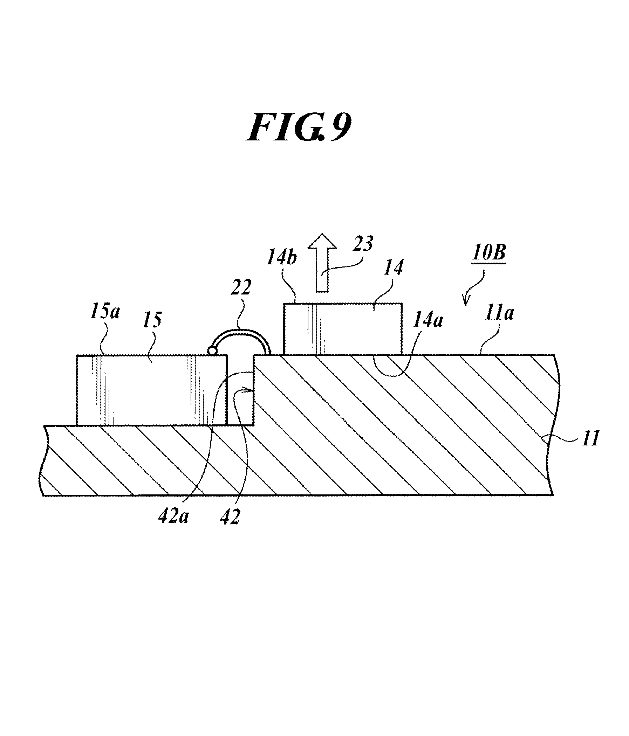

An optical module 10B according to a third embodiment will be described with reference to FIG. 9.

In the first and second embodiments, each of the surface emitting type semiconductor laser elements of the laser diode array 14 is a vertical cavity surface emitting laser (VCSEL), emitting a light (optical signal 23) from the front surface 14a side into the direction perpendicular to the board surface. On the other hand, each of the surface emitting type semiconductor laser elements of the laser diode array 14 used in the optical module 10B is a back surface light emitting type VCSEL, emitting a light (optical signal 23) from the back surface 14b side into the direction perpendicular to the board surface.

The features of the optical module 10B exist in the following configuration.
• Each of the surface emitting type semiconductor laser elements of the laser diode array 14 is a back surface light emitting type VCSEL.

• As shown in FIG. 9, the laserdiode array 14, including the plurality of surface emitting type semiconductor laser elements, is mounted on the board 11 by the flip chip mounting.

• The driver IC 15 is arranged in a recess section 42 formed on the board 11 in order that the height of the front surface 15a of the driver IC 15 and the height of the front surface 11a of the board 11 may be comparative levels in order that the wire lengths may be shortest.

• The driver IC 15 and a plurality of pieces of wiring (a part of the electrode pattern), to which the plurality of surface emitting type semiconductor laser elements of the laser diode array 14 are electrically connected, on the board 11 are electrically connected to each other, respectively, with the plurality of wires 22.
The other configuration is similar to that of the optical module 10 of the first embodiment, described above.

By such a configuration, the lengths of the plurality of wires (transmission lines) 22 for transmitting signals between the plurality of surface emitting type semiconductor laser elements of the laser diode array 14 and the driver IC 15, respectively, are made to be shortest.

The whole of the driver IC 15 is housed in the recess section 42 of the board 11 to be mounted on the bottom surface of the recess section 42 by being adhered thereto with, for example, a die attach adhesive. The recess section 42 is a rectangular hole having almost vertical wall surfaces 42a and a depth almost same as the height of the driver IC 15. The driver IC 15 is arranged in the recess section 42 in such a way that one of the end faces becomes close to one of the wall surfaces 42a. On the other hand, the laser diode array 14 is mounted on the electrode pattern of the board 11 in such a way that one of the end faces becomes to be close to the wall surface 42a. Then, the wiring (a part of the electrode pattern) to which the plurality of surface emitting type semiconductor laser elements of the laser diode array 14 are electrically connected and the driver IC 15 are electrically connected to each other, respectively, with the plurality of wires 22.

The third embodiment configured as described above takes the following operations and effects in addition to the operations and effects taken by the first embodiment described above.

○ Cross talk between adjacent transmission lines can be reduced in the optical module mounting the laser diode array 14 on the board 11 by the flip chip mounting, which laser diode array 14 includes the plurality of surface emitting type semiconductor laser elements, each being a back surface light emitting type VCSEL. In addition, the transmission lines for transmitting signals between the plurality of surface emitting type semiconductor laser elements of the laser diode array 14 and the driver IC 15 are composed of a plurality of pieces of wiring on the board 11 (a part of the electrode pattern), to which wiring the plurality of surface emitting type semiconductor laser elements of the laser diode array 14 are electrically connected, and the plurality of wires 22, respectively, in this case.

○ Because the wall surfaces 42a of the recess section 42 are made to be almost vertical, the laser diode array 14 and the driver IC 15 can be arranged to be close to each other, and the plurality of wires 22 can be shortened. Hereby, crosstalk between adjacent ones of the wires 22 can be reduced, and high speed parallel light transmission can be realized.

### (Fourth Embodiment)

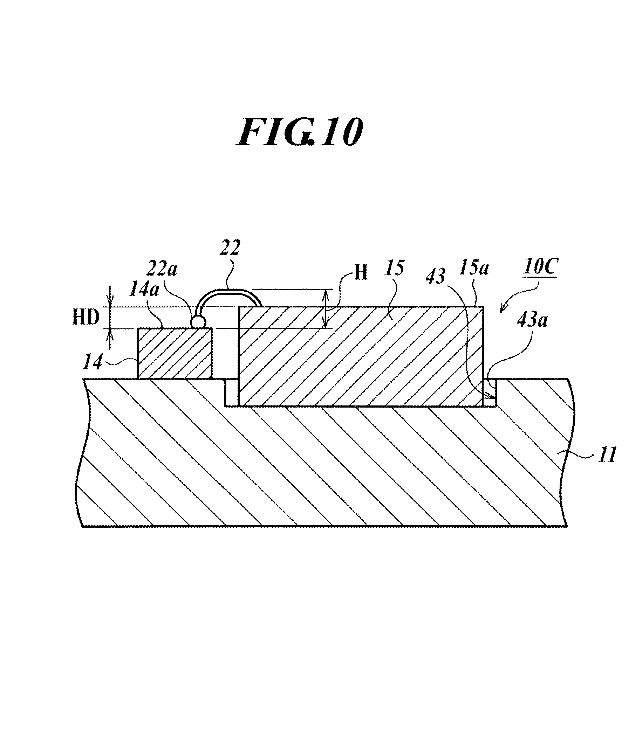

An optical module 10C according to a fourth embodiment will be described with reference to FIG. 10.

In the optical module 10 of the first embodiment described above, the lengths of the plurality of wires 22 are made to be shortest by making the height of the front surface 14a of the laser diode array 14 and the height of the front surface 15a of the drive IC 15 comparative levels in order that the wire lengths become shortest. On the other hand, the features of the optical modules 10C exist in the following configuration.

• The driver IC 15 is arranged in a recess section 43 formed in the board 11.

• The electrodes on the front surface 14a of the laser diode array 14 and the electrodes on the front surface 15a of the driver IC 15 are directly electrically connected to each other, respectively, with the plurality of wires 22.

• The front surface 15a of the driver IC 15 is made to be higher than the front surface 14a of the laser diode array 14 within a range in which no electrical short circuits are caused at the respective both ends of the plurality of wires 22.

The other configuration is similar to that of the optical module 10 of the first embodiment, described above.

The fourth embodiment configured as described above takes the following operation and effect in addition to the operations and effects taken by the first embodiment described above.

Each of the wire lengths can be shortened as short as possible without causing any electrical short circuits at the respective both ends of the plurality of wires 22. Hereby, cross talk between adjacent ones of the wires 22 can be reduced, and high speed parallel light transmission can be realized.

### (Example)

In the optical module 10C described above, gold wires each having a diameter ϕ of 25 µm were used as the plurality of wires 22. Furthermore, the front surface 15a of the drive IC 15 was made to be higher than the front surface 14a of the laser diode 14 in order that HD = H - (25 µm X 2), where H denoted the loop heights of the wires 22, and HD denoted the height from the front surface 14a of the laser diode array 14 to the front surface 15a of the driver IC 15. Balls 22a were mounted on the front surface 14a of the laser diode array 14.

According to the example, the wire lengths of the plurality of wires 22 could be shortened as short as possible without causing any electrical short circuits at the respective both ends of the wires 22.

### (Fifth Embodiment)

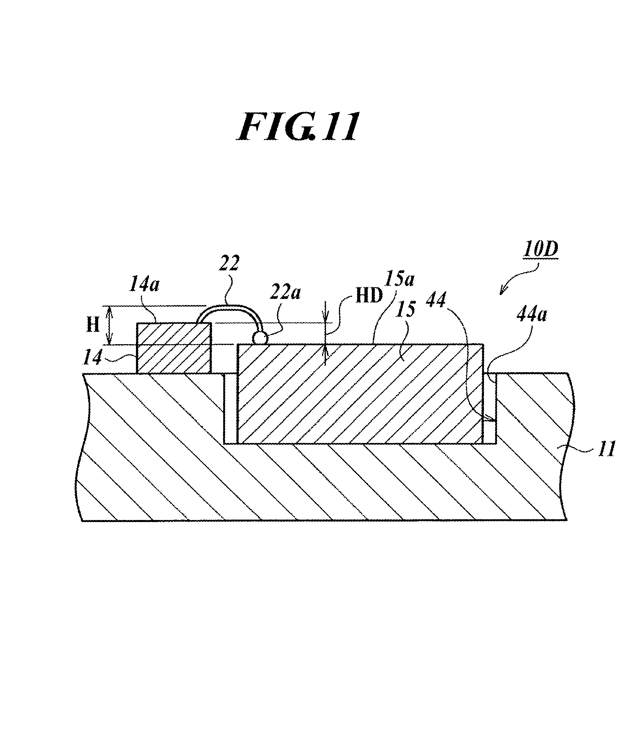

An optical module 10D according to a fifth embodiment will be described with reference to FIG. 11.

In the optical module 10 of the first embodiment described above, the lengths of the plurality of wires 22 are made to be shortest by making the height of the front surface 14a of the laser diode array 14 and the height of the front surface 15a of the driver IC 15 comparable levels. On the other hand, the features of the optical module 10C exist in the following configuration.

• The driver IC 15 is arranged in a recess section 44 formed in the board 11.

• The electrodes on the front surface 14a of the laser diode array 14 and the electrodes on the front surface 15a of the driver IC 15 are directly electrically connected to each other, respectively, with the plurality of wires 22.

• The front surface 14a of the laser diode array 14 is made to be higher than the front surface 15a of the driver IC 15 within a range of causing no electrical short circuits at the respective both ends of the plurality of wires 22.
The other configuration is similar to that of the optical module 10 of the first embodiment.

The fifth embodiment configured as described above takes the following operation and effect in addition to the operations and effects taken by the first embodiment described above.

Each of the wire lengths can be shortened as short as possible without causing any electrical short circuits at the respective both ends of the plurality of wires 22. Hereby, crosstalk between adjacent ones of the wires 22 can be reduced, and high speed parallel light transmission can be realized.

### (Example)

In the optical module 10D described above, gold wires each having a diameter ϕ of 25 µm are used as the plurality of wires 22. Furthermore, the front surface 14a of the laser diode 14 was made to be higher than the front surface 15a of the driver IC 15 in order that HD = H - (25 µm × 2), where H denoted the loop heights of the wires 22, and HD denoted the height from the front surface 14a of the laser diode array 14 to the front surface 15a of the driver IC 15. Balls 22a were mounted on the front surface 15a of the driver IC 15.

According to the example, the wire lengths of the plurality of wires 22 could be shortened as short as possible without causing any electrical short circuits at the respective both ends of the wires 22.

### (Sixth Embodiment)

The configuration of an optical module according to a sixth embodiment is similar to that of the optical module according to the first embodiment described with reference to FIGS. 1-7.
The optical module according to the sixth embodiment will be described with reference to FIGS. 1-7, 12, and 13.

FIG. 1 is a perspective view showing the principal part of the optical module according to the sixth embodiment, and FIG. 2 is a sectional view of FIG. 1. FIG. 3 is a longitudinal sectional view showing the schematic configuration of the optical module. FIG. 4A is a perspective view showing the whole optical module; FIG. 4B is an enlarged view showing one of a plurality of optical fibers to be used for the optical module; and FIG. 4C is a plan view showing the connection relation of the respective surface emitting type semiconductor laser elements of the laser diode array used for the optical module and a driver IC. FIG. 5 is an exploded perspective view showing the schematic configuration of the optical module; FIG. 6 is a perspective view of the optical connector section of the optical module; and FIG. 7 is a perspective view showing a state in which an external connector (multicore ferrule type connector) is mounted in the optical connector section of the optical module.

The optical module 10 according to the sixth embodiment is the one transmitting optical signals with the plurality of optical fibers in parallel. As shown in FIGS. 1 and 2, the optical module 10 includes the board 11, having an electrode pattern (not shown), a plurality of optical elements, mounted on the electrode pattern in a line, and an electronic device, mounted on the electrode pattern to be electrically connected to the plurality of optical elements.

The board 11 is a ceramic board. In the present embodiment, the plurality of optical elements are composed of the laser diode array 14, including the plurality of surface emitting type semiconductor laser elements (optical elements) aligned in a line. The mark 14a in FIG. 4C denotes each light emitting section (aperture section) of the plurality of surface emitting type semiconductor laser elements of the laser diode array 14. A surface emitting type semiconductor laser element as an optical element is a vertical cavity surface emitting laser (VCSEL), emitting a light (optical signal 23) into the direction perpendicular to a board surface.

Furthermore, the electronic device is a driver IC 15, driving the plurality of surface emitting type semiconductor laser elements of the laser diode array 14. As shown in FIGS. 1 and 2, the laser diode array 14 and the driver IC 15 are arranged on the board 11 at positions close to each other. To put it concretely, the laser diode array 14 is mounted on the front surface 11a of the board 11 by being adhered thereon with, for example, adieattachadhesive. A part of the driver IC 15 is housed in the recess section 40 on the board 11 to be mounted on the bottom surface of the recess section 40 by being adhered thereto with, for example, a die attach adhesive. The recess section 40 is a rectangular hole having the almost vertical wall surfaces 40a. The laser diode array 14 is arranged on the surface 11a of the board in such a way that an end face thereof is situated to be close to one of the wall surfaces 40a. On the other hand, the driver IC 15 is arranged on the bottom surface in such a way that one of the end faces of the driver IC 15 is situated to be close to the wall surface 40a. In this way, the laser diode array 14 and the driver IC 15 are arranged at positions on the board 11 close to each other. Then, the electrodes on the front surface 15a of the driver IC 15 and the electrode of the respective surface emitting type semiconductor laser elements on the front surface 14a of the laser diode array 14 are directly electrically connected to each other, respectively, with the plurality of wires 22 (see FIGS. 1, 2, and 4C).

Namely, the driver IC 15 and the plurality of surface emitting type semiconductor laser elements of the laser diode array 14 are electrically connected to each other, respectively, with the plurality of wires 22 without the wiring on the SiOB unlike the conventional technique. Hereby, the optical module 10 is adapted in order that a modulation signal may be input from the driver IC 15 to each of the surface emitting type semiconductor laser elements of the laser diode array 14 through each of the bonding wires 22, and that the optical signal 23, modulated by the modulation signal, is emitted from each of the surface emitting type semiconductor laser elements of the laser diode array 14. Furthermore, the driver IC 15 and the electrode pattern of the board 11 are electrically connected to each other with a not-shown plurality of bonding wires. The mark 22a in FIG. 4C denotes each ball mounted onto the electrode of each of the surface emitting type semiconductor laser elements.

The optical module 10 furthermore includes the optical connector section 12, the cover 13, and the two guide pins 32 as shown in FIGS. 3, 4A, and 5.

The optical connector section 12 holds the plurality of optical fibers 16, aligned in a line (in the direction perpendicular to the paper surface in FIG 3), as shown in FIGS. 4A-4C and 6. The optical connector section 12 is aligned by the active alignment in such a way that the center (core center) of each of the one ends 16a (see FIG. 4B) of the plurality of optical fibers 16 and the center of each of the light emitting sections 14a of the laser diode array 14 accord with each other, and, after that, the optical connector section 12 is fixed on the front surface 11a of the board 11. Hereby, the optical module 10 is adapted to optically couple each emitted light (optical signal 23) from each of the light emitting sections 14a of the laser diode array 14 to each of the one ends 16a of the optical fibers corresponding to the plurality of optical fibers 16.

Furthermore, the optical connector section 12 has side wall sections 17 on both sides as shown in FIG. 6. The lower end faces 17a of both the side wall sections 17 severally contact with the front surface 11a of the board 11 in a slidable state. The optical connector section 12 is two-dimensionally moved on the front surface 11a of the board 11 by the active alignment in order that the center of each of the one ends 16a of the plurality of optical fibers 16 and the center of each of the light emitting sections 14a of the laser diode array 14 may accord with each other, and after that, the lower end faces 17a of both the side wall sections 17 of the optical connector section 12 are fixed to the front surface 11a of the board 11 by adhering or the like.

Furthermore, as shown in FIG. 6, the optical connector section 12 includes the plurality of fiber holding holes 12a, to which the plurality of optical fibers 16 are fit, which fiber holding holes 12a are aligned in a line, and the two guide pin holes 12b formed on both the sides of the fiber holding holes 12a. The two guide pins 32 are adapted to be able to fit into the two guide pin holes 12b, respectively.

The two guide pins 32 are adapted to be able to fit into the two through-holes, respectively, of the MT connector 30, which is an external connector shown in FIG. 7. Byfitting the two through-holes of the MT connector 30 into the two guide pins 32, respectively, the MT connector 30 is adapted to be mounted onto the optical connector section 12, as shown in FIG. 7, in the state in which the core center of each of the optical fibers of the multicore optical fiber (multicore tape optical fiber) 31, held by the MT connector 30, and each of the core centers of the plurality of optical fibers 16, held by the optical connector section 12, accord with each other.

As shown in FIGS. 3, 4A, and 5, the cover 13 includes the aperture section 13a for mounting the optical connector section 12 and is fixed to the board 11 by adhesion or the like in order to cover all the parts, such as the laser diode array 14 and the driver IC 15. The cover 13 is made of a material having high thermal conductivity, such as an alloy of copper (Cu) and tungsten (W).

Furthermore, the resin 18, such as a resin sealing compound or an adhesive, is filled in the space between a side face of the optical connector section 12 and the aperture section 13a of the cover 13 as shown in FIG. 3. The silicone gel 19, having heat conductance and insulation properties, is filled in as a sealing compound in a gap (space) between the driver IC 15 and the cover 13. Furthermore, the transparent silicone gel 20 is filled in the space between one ends 16a of the plurality of optical fibers 16 and the respective light emitting sections 14a of the laser diode array 14 as a sealing compound.

The sixth embodiment, configured as described above, takes the following operations and effects.
○ Because the laser diode array 14 and the driver IC 15 are arranged on the board 11 at positions close to each other, the lengths of the plurality of transmission lines connecting the plurality of surface emitting type semiconductor laser elements of the laser diode array 14 and the driver IC 15 electrically become short, and crosstalk between adjacent transmission lines can be reduced. Hereby, high speed parallel light transmission can be realized.

○ The sixth embodiment is configured in order that the plurality of optical fibers 16 and the plurality of surface emitting type semiconductor laser elements of the laser diode array 14 may be optically coupled, respectively, by the active alignment by performing two-dimensional position adjustment of the optical connector section 12 on the board 11. Namely, by the active alignment, the center of each of the one ends 16a of the plurality of optical fibers 16 and the center of each of the light emitting sections 14a of the laser diode array 14 accord with each other. Consequently, the SiOB for performing the passive alignment becomes unnecessary unlike the conventional technique mentioned above, and the laser diode array 14 and the driver IC 15 can be arranged on the board 11 at positions close to each other. Hereby, the lengths of the plurality of wires 22 (transmission line lengths), connecting the plurality of surface emitting type semiconductor laser elements of the laser diode array 14 and the driver IC 15 to each other electrically, can be shortened, and crosstalk between adjacent transmission lines can be reduced.

○ Because the driver IC 15 and the plurality of surface emitting type semiconductor laser elements of the laser diode array 14 are directly electrically connected to each other with the plurality of wires 22, respectively, the wire lengths L (see FIG. 2) of the plurality of wires 22 become short. Hereby, crosstalk between adjacent wires can be reduced in the optical module mounting the driver IC 15 and the laser diode array 14 thereon by the wire bonding mounting.

### (Example)

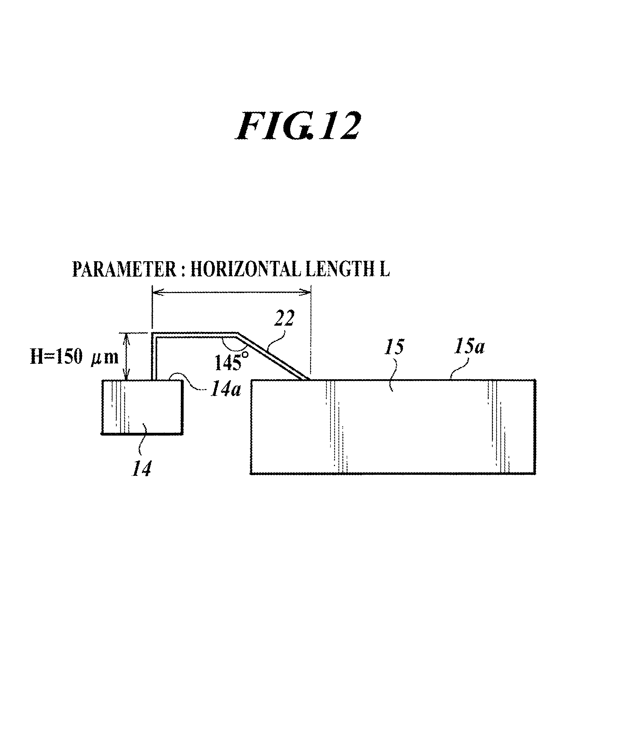

In the sixth embodiment, the lengths L of the wires (wire lengths) of the plurality of wires 22 in the horizontal direction of the wires were severally made 500 µm or less. In the present example, the wire of the shape shown in FIG. 12 was used as each of the wires 22. Furthermore, the front surface 14a of the laser diode array 14 and the front surface 15a of the driver IC 15 were made to be the same heights. Furthermore, the pitches between the plurality of wires 22 were made to be 250 µm.

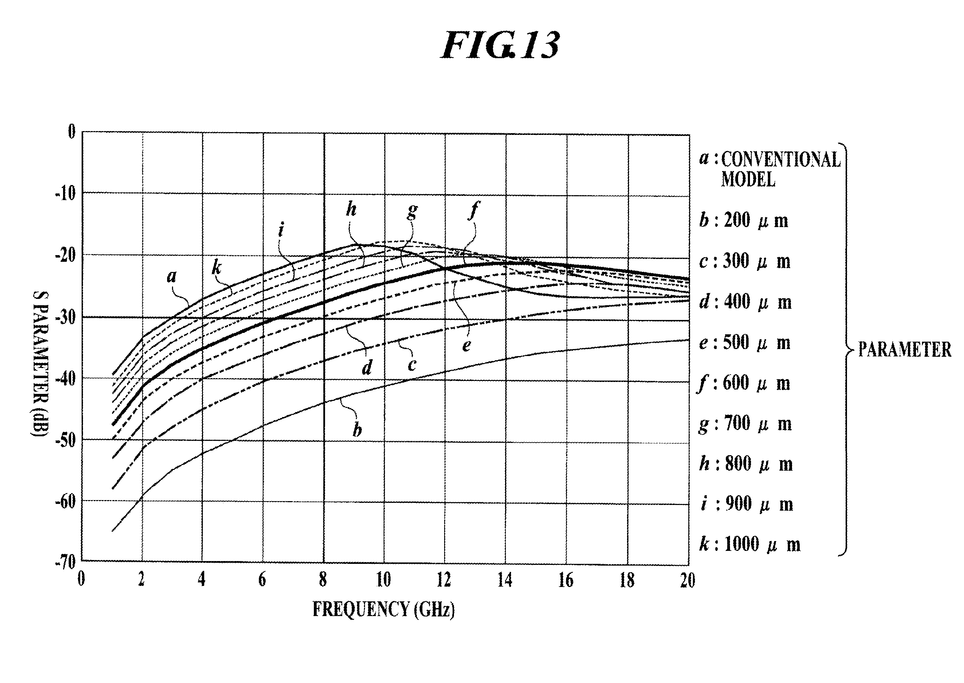

The graph of FIG. 13 shows the results of comparison of crosstalk between adjacent wires (between adjacent channels) in a conventional model and a proposed model. The conventional model is the optical module here, as the conventional technique mentioned above, which is configured in such a way that a plurality of optical elements are connected with wiring on an SiOB and wires, and that the wiring is connected to an electronic device with wires. The proposed model is the optical module 10 described in the sixth embodiment. The abscissa axis of FIG. 13 indicates the frequency (GHz) of the modulation signals to be transmitted from the driver IC to each of the surface emitting type semiconductor laser elements through the wires 22, and the ordinate axis indicates scattering parameters (S parameters) expressing the crosstalk components between channels, respectively.

In the graph of FIG. 13, a curved line indicates an S parameter when the frequency of a modulation signal in the conventional model is changed. From the curved line a, it is known that the crosstalk between adjacent wires (channels) cannot be suppressed to be 30 dB or less in a transmission band exceeding 3 GHz in the conventional model.

Furthermore, in the graph of FIG. 13, the S parameters when the frequency of the modulation signal is changed in the case where the lengths L (wire lengths) in the horizontal direction are changed to be 200 µm, 300 µm, 400 µm, 500 µm, 600 µm, 700 µm, 800 µm, 900 µm, and 1000 µm in the optical module 10 described above are shown by a curved line b, a curved line c, a curved line d, a curved line e, a curved line f, a curved line g, a curved line h, a curved line i, and a curved line k, respectively. From the curved lines b, c, d, and e, it is known that crosstalk between adjacent wires (channels) in a transmission band up to 8 GHz, which is necessary for the transmission of a signal of 10 Gbit/s, can be suppressed to be 30 dB or less by making the lengths L in the horizontal direction of the wires L 500 µm or less.

### (Seventh Embodiment)

The configuration of an optical module according to a seventh embodiment is similar to the one of the optical module according the second embodiment described with reference to FIG. 8.

The optical module 10A according to the seventh embodiment will be described with reference to FIG. 8.

In the sixth embodiment described above, the driver IC 15 is mounted on the electrode pattern of the board 11 by the wire bonding. On the other hand, in the optical module 10A according to the seventh embodiment, as shown in FIG. 8, the driver IC 15 is mounted on the electrode pattern of the board 11 by the flip chip mounting. The whole of the laser diode array 14 is hosed in the recess section 41 on the board 11 to be mounted on the bottom surface of the recess section 41 by being adhered thereto with, for example, a die attach adhesive. The recess section 41 is a rectangular hole having the almost vertical wall surfaces 41a and almost the same depth as the height of the laser diode array 14. The laser diode array 14 is arranged in the recess section 41 in such a way that one of the end faces is situated at a position near to one of the wall surfaces 41a. On the other hand, the driver IC 15 is mounted on the electrode pattern of the board 11 in such a way that one of the end faces is situated at a position close to the wall surface 41a. In this way, the laser diode array 14 and the driver IC 15 are arranged at positions on the board 11 close to each other. Then, the plurality of surface emitting type semiconductor laser elements of the laser diode array 14 and the wiring (a part of the electrode pattern), to which the driver IC 15 is electrically connected, are electrically connected to each other, respectively, with the plurality of wires 22.

The other configuration is similar to that of the optical module 10 of the sixth embodiment.
The seventh embodiment configured as described above takes the following operations and effects in addition to the operations and effects taken by the sixth embodiment.

○ The plurality of transmission lines are composed of the plurality of wires 22 by which the plurality of surface emitting type semiconductor laser elements of the laser diode array 14 and the driver IC 15 are electrically connected with each other, and the wiring to which the driver IC 15 is electrically connected. Hence, the lengths of the plurality of transmission lines are shortened. Hereby, cross talk between adjacent transmission lines can be reduced in the optical module mounting the driver IC 15 on the electrode pattern of the board 11 by the flip chip mounting.

○ Crosstalk between adjacent wires (channels) can be suppressed to be 30 dB or less at the time of transmission in a transmission band up to 8 GHz by making the lengths of the plurality of transmission lines 500 µm or less.

### (Eighth Embodiment)

The configuration of an optical module according to an eighth embodiment is similar to that of the optical module according to the third embodiment described with reference to FIG. 9.
The optical module 10B according to the eighth embodiment will be described with reference to FIG. 9.

In the sixth and seventh embodiments described above, each of the surface emitting type semiconductor laser elements of the laser diode array 14 is a vertical cavity surface emitting laser (VCSEL), emitting a light (optical signal 23) from the front surface side into the direction perpendicular to the board surface. On the other hand, each of the surface emitting type semiconductor laser elements of the laser diode array 14 used in the optical module 10B is a back surface light emitting type VCSEL, emitting a light (optical signal 23) from the back surface side into the direction perpendicular to the board surface.

In the optical module 10B, as shown in FIG. 9, the laser diode array 14 is mounted on the electrode pattern of the board 11 by the flip chip mounting. The whole of the driver IC 15 is housed in a recess section 42 on the board 11 and is mounted on the bottom surface of the recess section 42 by being adhered thereto with, for example, a die attach adhesive. The recess section 42 is a rectangular hole having the almost vertical wall surfaces 42a and almost the same depth as the height of the driver IC 15. The driver IC 15 is arranged in the recess section 42 in such a way that one of the end faces of the driver IC 15 is situated close to one of the wall surfaces 42a. On the other hand, the laser diode array 14 is mounted on the electrode pattern of the board 11 in such a way that one of the end surfaces of the laser diode array 14 is situated to be close to the wall surface 42a. In this way, the laser diode array 14 and the driver IC 15 are arranged at positions on the board 11 close to each other. Then, the plurality of pieces of wiring (a part of the electrode pattern), to which the plurality of surface emitting type semiconductor laser elements of the laser diode array 14 is electrically connected, and the driver IC 15 are electrically connected to each other, respectively, with the plurality of wires 22.
The other configuration is similar to that of the optical module 10 of the sixth embodiment, described above.

The eighth embodiment configured as described above takes the following operations and effects in addition to the operations and effects taken by the first embodiment described above.

Cross talk between adjacent transmission lines can be reduced in the optical module mounting the laser diode array 14 on the board 11 by the flip chip mounting, which laser diode array 14 includes the plurality of surface emitting type semiconductor laser elements, each being a back surface light emitting type VCSEL.

In addition, the present invention can be embodied by changing as follows.
• The optical modules 10, 10A, 10B, 10C, and 10D, configured as the transmission side optical modules, have been described in the respective embodiments described above, but the present invention is not limited to the transmission side optical modules. A photodiode array having a plurality of photodiode elements (optical elements) aligned in a line may be used in each of the optical modules 10, 10A, 10B, 10C, and 10D in place of the laser diode array 14. Then, the present invention can also be applied to an optical module configured as a reception side optical module using an amplifying IC having the transimpedance amplifier (TIA) function converting the output current of each photodiode into a voltage to amplify the converted voltage in place of the driver IC 15.

• Furthermore, the present invention can also be applied to an optical module mounting a plurality of surface emitting type semiconductor laser elements (optical elements) aligned in a line in place of the laser diode array 14, or an optical module mounting a plurality of photodiodes (optical elements) aligned in a line in place of the photodiode array.

### Industrial Applicability

The present invention can be used in the field of optical communication, and can be applied to an optical module transmitting optical signals in parallel with optical fibers.

### Description of Reference Numerals

10, 10A, 10B, 10C, 10D: optical module
11: board
11a: front surface
12: optical connector section
13: cover
14: laser diode array
14a: front surface
15: driver IC (electronic device)
15a: front surface
16: optical fiber
16a: one end
22: wire
23: optical signal
30: multicore optical fiber connector (MT connector)
31: multicore optical fiber (multicore tape optical fiber)
40, 41, 42, 43, 44: recess section
40a, 41a, 42a, 43a, 44a: wall surface

## Claims

1. An optical module for transmitting light signals in parallel with a plurality of optical fibers, the optical module comprising:
a board having an electrode pattern;
a plurality of optical elements which are mounted on the electrode pattern of the board; and
an electronic device which is mounted on the electrode pattern of the board and which is electrically connected to the plurality of optical elements, wherein
the plurality of optical elements and the electronic device are arranged on the board in such that lengths of transmission lines for transmitting signals between the plurality of optical elements and the electronic device become shortest.

2. The optical module according to claim 1, further comprising
an optical connector section for holding the plurality of optical fibers, said optical connector section being fixed on the board at a position where the plurality of optical fibers and the plurality of optical elements are optically coupled to each other, respectively, wherein
a position of the optical connector section can be adjusted two-dimensionally on the board.

3. The optical module according to claim 1 or 2, wherein
the electronic device is arranged in a recess section formed on the board such that heights of surfaces of the plurality of optical elements and a height of a surface of the electronic device become comparative levels such that wire lengths become shortest, and
the surfaces of the plurality of optical elements and the surface of the electronic device are directly electrically connected to each other, respectively, with a plurality of wires as the transmission lines.

4. The optical module according to claim 3, wherein
the recess section has essentially vertical wall surfaces;
the plurality of optical elements are arranged on the board so as to align along one of the wall surfaces at a position close to the one of the wall surfaces; and
the electronic device is arranged in the recess section at a position close to said one wall surface.

5. The optical module according to claim 1 or 2, wherein
the electronic device is mounted on the board by flip chip mounting;
the plurality of optical elements are arranged in a recess section formed on the board such that heights of surfaces of the plurality of optical elements and a height of a surface of the electronic device become comparative levels such that wire lengths become shortest; and
the plurality of optical elements and wiring on the board, to which wiring of the electronic device is electrically connected, are electrically connected to each other with a plurality of wires.

6. The optical module according to claim 1 or 2, wherein
the plurality of optical elements are surface emitting type semiconductor laser elements for emitting a light from their back surface side;
the plurality of optical elements are mounted on the board by flip chip mounting;
the electronic device is arranged in a recess section formed on the board such that a height of a front surface of the electronic device and a height of a front surface of the board become comparative levels such that wire lengths become shortest; and
the electronic device and wiring on the board, to which wiring the plurality of optical elements are electrically connected, are electrically connected to each other with a plurality of wires.

7. The optical module according to claim 1 or 2, wherein
the electronic device is arranged in a recess section formed on the board;
surfaces of the plurality of optical elements and a surface of the electronic device are directly electrically connected to each other with a plurality of wires as the transmission lines; and
the surface of the electronic device is made to be higher than the surfaces of the plurality of optical elements within a range in which no electrical short circuits are caused at respective both ends of the plurality of wires.

8. The optical module according to claim 1 or 2, wherein
the electronic device is arranged in a recess section formed on the board;
surfaces of the plurality of optical elements and a surface of the electronic device are directly electrically connected to each other with a plurality of wires as the transmission lines; and
the surfaces of the plurality of optical elements are made to be higher than the surface of the electronic device within a range in which no electrical short circuits are caused at respective both ends of the plurality of wires.

9. The optical module according to any one of claims 1 - 8, wherein
the optical module includes a plurality of surface emitting type semiconductor laser elements as the optical elements and a driver IC as the electronic device, wherein the driver IC drives the plurality of surface emitting type semiconductor laser elements, and
the optical module is configured as a transmission side optical module to transmit the optical signals to be emitted from the plurality of surface emitting type semiconductor laser elements, respectively, to an outside through the plurality of optical fibers in parallel.

10. The optical module according to any one of claims 1 - 8, wherein
the optical module includes a plurality of photodiodes as the optical elements and an amplifying IC as the electronic device, which amplifying IC has a function for converting output currents of the photodiodes into voltages for amplifying the voltage, and
the optical module is configured as a reception side optical module to receive the optical signals, which are transmitted in parallel from an outside through the plurality of optical fibers, wherein the plurality of photodiodes convert the received optical signals into electric signals.

11. An optical module for transmitting optical signals in parallel with a plurality of optical fibers, the optical module comprising:
a board having an electrode pattern;
a plurality of optical elements which are mounted on the electrode pattern of the board; and
an electronic device which is mounted on the electrode pattern of the board and which is electrically connected to the plurality of optical elements, wherein
the plurality of optical elements and the electronic device are arranged at positions close to each other on the board.

12. The optical module according to claim 11, further comprising an optical connector section for holding the plurality of optical fibers, wherein the optical connector section is fixed to the board at a position where the plurality of optical fibers and the plurality of optical elements are optically coupled to each other, respectively, wherein
a position of the optical connector section can be adjusted two-dimensionally on the board.

13. The optical module according to claim 11 or 12, wherein the electronic device and the plurality of optical elements are directly electrically connected to each other, respectively, with a plurality of wires.

14. The optical module according to claim 13, wherein any length of the plurality of wires in a horizontal direction is made to be 500 µm or less.

15. The optical module according to claim 11 or 12, wherein
the electronic device is mounted on the board by flip chip mounting, and
the plurality of optical elements and wiring on the board, to which the electronic device is electrically connected, are electrically connected to each other, respectively, with a plurality of wires.

16. The optical module according to claim 15, wherein lengths of a plurality of transmission lines composed of the plurality of wires and the wiring, wherein the wires and the wiring electrically connect the plurality of optical elements and the electronic device, respectively, are made to be 500 µm or less.

17. The optical module according to any one of claims 11-16, wherein the optical module is configured as a transmission side optical module including a plurality of surface emitting type semiconductor laser elements as the optical elements and a driver IC as the electronic device for driving the plurality of surface emitting type semiconductor laser elements, wherein the transmission side optical module transmits optical signals emitted from the plurality of surface emitting type semiconductor laser elements, respectively, in parallel to an outside through the plurality of optical fibers.

18. The optical module according to any one of claims 1-16, wherein the optical module is configured as a reception side optical module including a plurality of photodiodes as the optical elements and an amplifying IC as the electronic device having a function of converting output currents of the photodiodes into voltages for amplifying the voltages, wherein the reception side optical module receives optical signals transmitted in parallel from an outside through the plurality of optical fibers wherein the plurality of photodiodes convert the received optical signals into electric signals.
